# EUROPÄISCHE PATENTSCHRIFT

(11) **EP 2 063 444 B1**
(45) Veröffentlichungstag und Bekanntmachung des Hinweises auf die Patenterteilung: **20.01.2010**
(21) Anmeldenummer: 08020145.2
(22) Anmeldetag: 19.11.2008
(51) Int. Cl.: H01H 3/22, H01H 19/02

(54) **Bedieneinrichtung für ein Elektrogerät und Verfahren zum Betrieb einer Bedieneinrichtung**
Operating device for an electrical device and method of operating an operating device
Dispositif de commande pour un appareil électrique et procédé de fonctionnement d'un dispositif de commande

(30) Priorität: 21.11.2007 DE 102007057087
(43) Veröffentlichungstag der Anmeldung: 27.05.2009
(73) Patentinhaber: E.G.O. Elektro-Gerätebau GmbH, 75038 Oberderdingen (DE)
(72) Erfinder: Baier, Martin, 75038 Oberderdingen (DE); Boss, Roland, 75038 Oberderdingen (DE); Hamm, Wolfgang Alfred, Dr., 75038 Oberderdingen (DE); Metzger, Wolfgang, 75038 Oberderdingen (DE)
(74) Vertreter: Renger, Florian

(56) Entgegenhaltungen:
- DE-A1- 10 256 464
- DE-A1-102004 049 011
- US-A1- 2004 011 154

## Beschreibung

Die Erfindung betrifft eine Bedieneinrichtung für ein Elektrogerät wie beispielsweise ein Haushalts-Elektrogerät in Form eines Elektroherdes oder Backofens, sowie Verfahren zum Betrieb einer solchen Bedieneinrichtung.

Bedienelemente wie beispielsweise Drehknebel oder auch Joysticks bei Computer-Spielkonsolen mit so genannter aktiver Haptik sind bekannt, bei denen durch beispielsweise einen Elektromotor haptische Rückmeldungen an einen Bediener gegeben werden können, wodurch beispielsweise eine gewisse, möglicherweise sich verändernde Bewegbarkeit erzeugt wird. Des weiteren können so auch Anschläge oder eine Rastung nachgebildet werden. Problematisch dabei ist, dass in der Praxis die Einrichtung, die die haptische Rückmeldung erzeugt, stets aktiviert ist und somit Energie verbraucht, auch wenn sie die meiste Zeit über nicht benutzt wird, zumindest bei eingeschaltetem Elektrogerät. Da jedoch bei jeder Bedienung die haptische Rückmeldung dann doch erwünscht ist, können Möglichkeiten wie zeitgesteuertes Abschalten nicht oder nur

schwer realisiert werden. DE-A-10256464 offenbart eine Bedieneinrichtung mit einem Näherungssensor und Bedienungselementen, die in verschiedenen Bereitschaftsstenfen gebracht werden können.

### Aufgabe und Lösung

Der Erfindung liegt die Aufgabe zugrunde, eine eingangs genannte Bedieneinrichtung sowie Verfahren zu deren Betrieb zu schaffen, mit denen Nachteile des Standes der Technik beseitigt werden können und insbesondere eine praxistaugliche, komfortable und gleichzeitig energiesparende Bedieneinrichtung zur Verfügung gestellt werden kann.

Gelöst wird diese Aufgabe durch eine Bedieneinrichtung mit den Merkmalen des Anspruchs 1 sowie Verfahren mit den Merkmalen des Anspruchs 10, 11, 12 oder 13. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Es ist vorgesehen, dass die Bedieneinrichtung mindestens ein bewegbares Bedienelement aufweist. Es kann ein Drehregler oder ein Schieberegler sein, ebenso ein vorgenannter Joystick oder ein ähnliches, vielfältig bewegbares Bedienelement. Durch entsprechende Bewegung des Bedienelements können verschiedene Funktionen ausgelöst werden bzw. eine Bedienung erfolgt auf an sich bekannte Art und Weise. Das Bedienelement ist mit einer Aktuatoreinrichtung kraftverbunden, beispielsweise über eine Drehwelle oder Lagerwelle, um eine haptische Rückmeldung bei Bewegung des Bedienelements zu erzeugen, welche entweder immer gegeben sein kann, beispielsweise als vorgenannte Rastung bei verschiedenen Einstellungsstufen oder auch unterschiedliche Schwergängigkeit. Alternativ kann die haptische Rückmeldung über die Aktuatoreinrichtung im Zusammenhang mit dieser speziellen Bedienung stehen, beispielsweise auch ausgelöst sein von einem vorherrschenden oder durch die Bedienung eingestellten Betriebszustand des Elektrogeräts.

Erfndungsgemäß weist die Bedieneinrichtung einen Näherungssensor oder Berührungssensor auf sowie eine Steuerschaltung, die die Bedieneinrichtung bzw. die Aktuatoreinrichtung von einem Normal-Modus in einen Stand-by-Modus versetzen kann. In diesem Stand-by-Modus ist der Energieverbrauch der Aktuatoreinrichtung reduziert. Dabei ist die Steuerschaltung so ausgebildet, dass sie in einem ersten Fall einer erkannten Annäherung oder Berührung des Bedienelements durch eine Bedienperson, in der Regel mit der Hand, dies als solche erkennt und die Aktuatoreinrichtung aus dem Stand-by-Modus heraus aktiviert, insbesondere wieder in den vollen Funktionszustand versetzt, also in den Normal-Modus. Dabei arbeitet die Aktuatoreinrichtung wieder sofort. In einem zweiten Fall von nicht vorliegender Annäherung oder Berührung an das Bedienelement bzw. wenn der Näherungs- oder Berührungssensor erkennt, dass eine Hand zurückgezogen worden ist, versetzt die Steuerschaltung die Aktuatoreinrichtung von dem Normal-Modus in den Stand-by-Modus bzw. belässt sie darin.

Somit kann sich also sozusagen in einem Grundzustand die Aktuatoreinrichtung in einem Standby-Modus mit reduziertem Energieverbrauch befinden. Vorteilhaft ist sie dabei im Wesentlichen oder ganz abgeschaltet und entfaltet somit eben auch keinerlei Wirkung. Nähert sich eine Bedienperson, in der Regel mit der Hand, dem Bedienelement an oder berührt es dieses direkt, so erkennt dies die Steuerschaltung über den Näherungs- oder Berührungssensor sofort und aktiviert die Aktuatoreinrichtung, versetzt sie also in volle Funktionsbereitschaft, unter Umständen auch schon so, dass ein gewisser Widerstand gegeben ist. Dies kann sehr schnell erfolgen, so dass eine Bedienperson kaum oder gar nicht merkt, dass das Bedienelement bzw. dessen Aktuatoreinrichtung gerade erst aktiviert worden ist. Für eine nun folgende Bedienung funktioniert die Aktuatoreinrichtung vollständig. Entfernt die Bedienperson die Hand wieder von dem Bedienelement, so erkennt dies die Steuerschaltung über den Näherungs- oder Berührungssensor erneut. Je nach Art des Elektrogerätes oder des gewünschten Betriebs kann nun entweder sofort die Aktuatoreinrichtung wieder von dem Normal-Modus in den Stand-by-Modus versetzt bzw. zumindest teilweise, insbesondere vollständig, abgeschaltet werden. Alternativ kann hier eine Zeitabschaltung nach einer vorgegebenen Zeit erfolgen, beispielsweise nach zehn Sekunden, einer Minute oder wenigen Minuten. Dadurch kann dem Umstand Rechnung getragen werden, dass, wenn das Bedienelement einmal bedient worden ist, mit großer Wahrscheinlichkeit in nächster Zeit entweder keine oder aber eben, je nach Art des Elektrogeräts, doch wieder eine weitere Bedienung folgt.

Mit der Erfindung ist es somit möglich, die tatsächlich eingeschaltete bzw. aktivierte Zeit der Aktuatoreinrichtung stark zu reduzieren bzw. bei manchen Elektrogeräten auf einen Bruchteil zu reduzieren bei gleichzeitig jederzeitiger voller Betriebs-Funktionalität der Aktuatoreinrichtung zur haptischen Rückmeldung an eine Bedienperson.

Ein Näherungssensor kann vorteilhaft so ausgebildet sein und betrieben werden, dass eine Annäherung auf weniger als 10 cm, besonders vorteilhaft sogar weniger als 5 cm, die Aktivierung bewirkt, um die Steuerung vom Stand-by-Modus in den Normal-Modus zu versetzen. Das reicht zeitlich aus bis zur tatsächlichen Berührung und kann gleichzeitig eine unnötige Aktivierung vermeiden.

Das Bedienelement kann vorteilhaft, wie zuvor genannt worden ist, ein Drehknebel mit einer Drehachse sein. Insbesondere ist es eine starre Drehwelle bzw. eine durchgängige Drehwelle zwischen dem Drehknebel bzw. der Handhabe selber und einem Einstellgerät, beispielsweise einem Leistungssteuergerät. Alternativ zu einer solchen starren Drehwelle kann auch eine magnetische Kopplung vorgesehen sein, wie sie beispielsweise aus der DE 10 2006 054 764 A1 bekannt ist. Die Aktuatoreinrichtung wirkt dann vorteilhaft auf die Drehachse und ist dazu mit der Drehwelle verbunden, mindestens aber kraftverbunden mit dem Bedienelement.

Einerseits kann der Näherungs- oder Berührungssensor als reiner Berührungssensor ausgebildet sein, also erst dann ansprechen bzw. eine Bedienung registrieren, wenn er berührt worden ist. Dies ermöglicht eine relativ sichere Erkennung einer Berührung, die sehr störungsfrei arbeitet. Ein derartiger Berührungssensor ist dann vorteilhaft am Bedienelement selber angeordnet, insbesondere an einer Stelle, die bei Bedienung sozusagen automatisch bzw. auf alle Fälle berührt wird. Derartige Berührungssensoren an einem Drehknebel sind beispielsweise aus der vorgenannten DE 10 2006 054 764 A1 zu entnehmen. Der Vorteil von kapazitiven Berührungssensoren liegt in der erprobten Anwendung sowie auch darin, dass keinerlei bewegbaren mechanischen Teile notwendig sind. Eingebaut in ein Bedienelement oder einen Drehknebel können sie wie in der DE 20 2005 019 978 U1 beschrieben sein. Alternativ können Berührungssensoren auf Basis einer Reflektions-Lichtschranke verwendet werden, wie sie beispielsweise in der DE 197 00 836 C1 beschrieben sind.

Ein Berührungssensor an dem Bedienelement kann als freiliegende elektrisch leitfähige Fläche ausgebildet sein, beispielsweise aus Metall wie Edelstahl odgl.. Ein Berührungssensor kann alternativ mit einer isolierenden Beschichtung überzogen sein oder unter einer Abdeckung am Bedienknebel sitzen. Wichtig bei der Ausbildung als kapazitiver Sensor ist eben, dass er kapazitiv eine Berührung mit der Hand erkennen kann und dies an die Steuerung weitergibt. Bei genügend großer Empfindlichkeit kann mit einem derartigen kapazitiven Sensor auch ein Näherungssensor aufgebaut sein, da die kapazitive Kopplung zwischen Sensor und Hand auch eine Strecke von einigen cm durch die Luft überbrückt.

Andererseits kann ein Näherungssensor verwendete werden, der nicht erst bei direkter Berührung die Aktuatoreinrichtung aktiviert, sondern eine gewünschte bzw. wahrscheinliche Bedienung und Berührung bereits einige Zentimeter vor dem Bedienelement und somit bereits einige Millisekunden vorher erkennt, vorteilhaft maximal ein oder zwei Sekunden. Diese Zeitspanne kann vorteilhaft genutzt werden, um im Moment des Berührens des Bedienelements die Aktuatoreinrichtung bereits aktiviert zu haben. So ist es möglich, dass eine Bedienperson von dem vorherigen Stand-by-Modus des Bedienelements gar nichts bemerkt. Derartige Näherungssensoren können ebenfalls, wie vorbeschrieben, auf kapazitiver Basis ausgebildet sein. Alternativ können sie als Reflektions-Lichtschranke ausgebildet sein gemäß der DE 197 00 836 C1 und dann eben erkennen, wenn sich eine Bedienperson mit der Hand beispielsweise auf bis zu 10cm oder weniger an das Bedienelement annähert.

Gerade bei der Verwendung von Näherungssensoren kann vorgesehen, dass für den Fall, dass das Entfernen einer Hand von dem Bedienelement erkannt wird, die Aktuatoreinrichtung umgehend in den Standby-Modus versetzt wird, also ohne vorgenannte Nachlaufzeit mittels einer Zeitabschaltung. Eine erneute Bedienung kann dann nämlich wiederum sozusagen vorausschauend erkannt werden. Des weiteren kann bei einem Näherungssensor, ähnlich wie im Wesentlichen bei einem Berührungssensor, die Steuerschaltung derart eingestellt werden, dass der Sensor bzw. seine Auswertung tendenziell häufiger eine anwesende Hand eines Bedieners erkennt als nicht, also schneller anspricht, so dass im Zweifelsfall die Aktuatoreinrichtung eher zu häufig und unter Umständen unnötig eingeschaltet wird als zu selten. Selbst wenn dadurch der Energieverbrauch wiederum etwas erhöht wird, wirkt sich insgesamt die Verringerung des Energieverbrauchs durch das Schalten in den Standby-Modus erheblich stärker aus. Ein Näherungssensor kann nicht nur an dem Bedienelement selber angeordnet sein, sondern auch an dem Elektrogerät selber bzw. an einer Bedienblende, an oder vor der das Bedienelement angeordnet ist. Vorteilhaft ist es auch möglich, einen Näherungssensor für mehrere Bedienelemente zu verwenden, besonders vorteilhaft für alle Bedienelemente an der Bedienblende bzw. Bedieneinrichtung. Dies ist bei einem Berührungssensor kaum möglich.

Als Aktuatoreinrichtung können grundsätzlich beliebige, vorteilhaft verwendete Aktuatoreinrichtungen eingesetzt werden, beispielsweise entweder mit Elektromotor, mit Piezoelementen oder mit Magnetwirkung, beispielsweise mit Magnetostriktion.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Schrägansicht eines erfindungsgemäßen Kochfelds an einem Herd mit mehreren Bedienknebeln an einer Vorderblende vor einer Kochfeldplatte,
- Fig. 2: einen Schnitt durch die Vorderblende des Kochfelds aus Fig. 1 mit einer Näherungssensorik über dem Bedienknebel und
- Fig. 3: eine Abwandlung der Darstellung aus Fig. 2 mit einem Berührungssensor direkt am Bedienknebel.

### Detaillierte Beschreibung der Ausführungsbeispiele

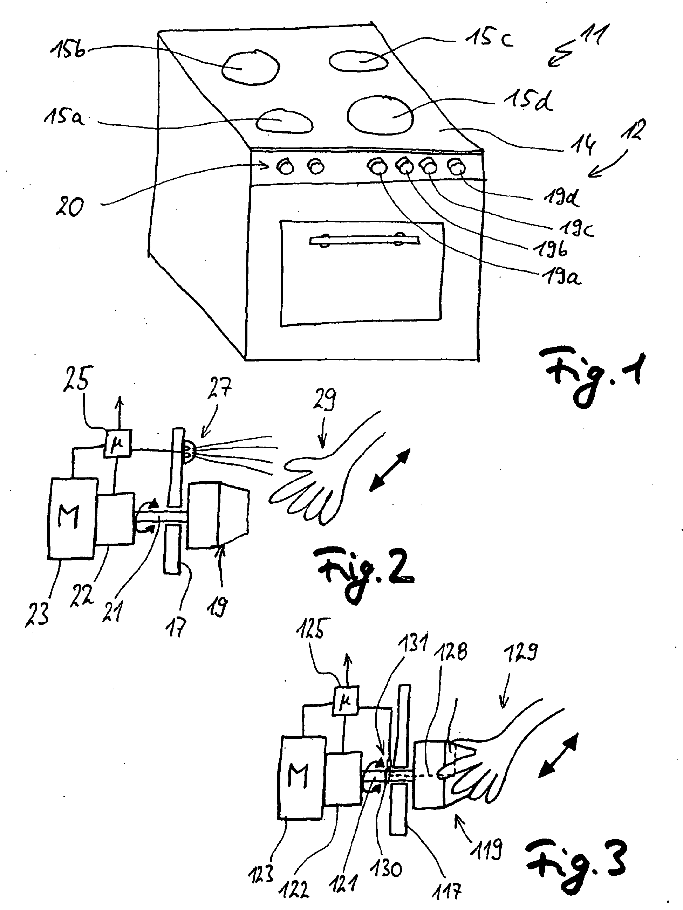

In Fig. 1 ist eine Schrägansicht eines Kochfeldes 11 an einem Herd 12 dargestellt. Das Kochfeld 11 weist eine Kochfeldplatte 14 auf, beispielsweise aus lichtdurchlässiger Glaskeramik, mit vier verteilt angeordneten Kochstellen 15a-d, wie dies aus dem Stand der Technik bekannt ist. Vorne an dem Herd 12 unterhalb des Kochfeldes 11 ist eine Vorderblende 17 vorgesehen, unter der ein Backofen angeordnet ist, auf den nicht näher eingegangen wird. Rechts an der Vorderblende 17 sind vier Bedienknebel 19a-d vorgesehen. Des Weiteren sind links an der Vorderblende 17 zwei Bedienknebel 20 für die Funktionen des Backofens vorgesehen. Der Bedienknebel 19a ist der Kochstelle 15a zugeordnet zu ihrer Bedienung bzw. zu deren Leistungseinstellung. Dies gilt entsprechend auch für die übrigen Kochstellen und die übrigen Bedienknebel.

Wie aus dem Stand der Technik bekannt, kann also mit dem Bedienknebel 19a die Kochstelle 15a bedient werden, also eingeschaltet und in ihrer Leistungshöhe eingestellt werden. Die in Fig. 1 dargestellte Anordnung entspricht einer üblichen Anordnung, so dass die Bedienknebel also von links nach rechts den Kochstellen links vorne beginnend im Uhrzeigersinn folgend zugeordnet sind. Damit eine Bedienung instinktiv erfolgen kann, beispielsweise mit einer stufenartigen oder sich zunehmend schwerer betätigbaren Leistungseinstellung, ist eine entsprechende haptische Rückmeldung erwünscht. Dies wird nachfolgend näher erläutert.

Gemäß einem ersten Aspekt der Erfindung ist in Fig. 2 ein schematischer Schnitt durch eine Vorderblende 17 gemäß Fig. 1 dargestellt. Der Bedienknebel 19 sitzt auf einer Drehwelle 21, welche durch die ansonsten geschlossene Vorderblende 17 reicht an ein an sich übliches Leistungssteuergerät 22. Durch Drehen des Bedienknebels 19 kann über das Leistungssteuergerät 22 eine Leistungseinstellung an der zugehörigen Kochstelle 15 bzw. deren Heizeinrichtung vorgenommen werden.

Um nun die gewünschte haptische Rückmeldung zu erhalten ist hinten an dem Leistungssteuergerät 22 eine Aktuatoreinrichtung 23 vorgesehen, die insbesondere mit der durchgehenden Drehwelle 21 verbunden ist. Die Aktuatoreinrichtung 23 ist an sich bekannt, beispielsweise mit einem Elektromotor oder einem Elektromagnet.

Oberhalb des Bedienknebels 19 ist an der Vorderblende 17 eine Näherungssensorik 27 vorgesehen mit Wirkrichtung in einen Bereich vor der Vorderblende 17. Diese Näherungssensorik 27 ist auch mit der Steuerung 25 verbunden, die, wie hier dargestellt ist, auch mit dem Leistungssteuergerät 22 verbunden ist. Des Weiteren ist die Steuerung 25 mit der Aktuatoreinrichtung 23 verbunden, um sowohl die Signale des Leistungssteuergeräts 22 zu berücksichtigen als auch weitere externe Faktoren, um davon abhängig die Aktuatoreinrichtung 23 anzusteuern.

Die Näherungssensorik 27 ist an sich aus dem Stand der Technik bekannt und kann beispielsweise als sogenannte Reflektions-Lichtschranke ausgebildet sein. Insofern kann sie, wie angedeutet ist, Licht aussenden, vorteilhaft mit einem Sender im IR-Bereich. Wird nun eine Hand 29 nahe an den Bedienknebel 19 gebracht, insbesondere in einem vordefinierten Abstand, beispielsweise weniger als 10 cm bzw. etwa 5 cm bis 10 cm, so wird Licht von ihr reflektiert. Das wiederum kann die Näherungssensorik 27 zusammen mit der Steuerung 25 feststellen. Dies wird dann von der Steuerung als Annäherung und beabsichtigte Bedienung ausgewertet und ein Anzeigemittel, welches der diesem Bedienknebel 19 zugeordneten Kochstelle zugeordnet ist, aktiviert.

Bedeutsam ist bei dieser Ausführung der Erfindung die Entfernung von dem Bedienknebel 19 bzw. der Vorderblende 17, bei der die Näherungssensorik 27 die Hand 29 erkennt. Dabei muss eben vor allem auch erkannt werden, ob sich die Hand 29 tatsächlich einem Bedienknebel nähert. Insofern kann pro Bedienknebel 19 eine solche Näherungssensorik 27 vorgesehen sein. Diese kann natürlich auch in die Vorderblende 17 hinein oder versenkt oder dahinter angeordnet sein mit einem lichtdurchlässigen Fenster odgl.. Alternativ können, beispielsweise über den ganz linken Bedienknebel 19a und den ganz rechten Bedienknebel 19d, insgesamt zwei ähnliche Näherungssensoriken vorgesehen sein. Sie können den gesamten Bereich vor den Bedienknebeln 19 überwachen. Dann werden zwar bei Erkennen einer Annäherung durch die Hand 29 alle Aktuatoreinrichtungen 23 aller Bedienknebel 19 aktiviert. Dieser Mehraufwand bzw. gesteigerte Energieverbrauch hinsichtlich der nicht bedienten Bedienknebel ist aber noch gut vertretbar, wenn dadurch nicht für jeden Bedienknebel eine Näherungssensorik 27 benötigt wird.

Ein Abstand von deutlich mehr als 10 cm macht für die Erkennung einer Annäherung an einen der Bedienknebel 19 eigentlich keinen Sinn mehr, da in dieser Entfernung auch ein zufälliges Vorbeibewegen stattfinden kann, zumindest bei einem dargestellten Kochfeld. Ein Aktivieren eines Bedienknebels 19 bzw. dessen Aktuatoreinrichtung 23 sollte erst dann erfolgen, wenn erkannt werden kann, ob sich eine Hand 29 einigermaßen wahrscheinlich einem Bedienknebel 19 nähert.

Vorgenannte Probleme einer gewissen Unsicherheit bei der Annäherung einer Hand an einen Bedienknebel können mit der Anordnung gemäß einer alternativen Ausführung der Erfindung nach Fig. 3 vermieden werden. Hier ist bei einem weitgehend ähnlichen Aufbau eines Bedienknebels 119 an einer Vorderblende 117 ein Berührungssensor 127 direkt an dem Bedienknebel 119 vorgesehen. Dieser Berührungssensor 127 besteht vorteilhaft aus Metall, beispielsweise Edelstahl, bzw. ist elektrisch leitfähig und bildet mindestens den vorderen Teil des Bedienknebels 119, der üblicherweise angefasst wird, oder sogar die gesamte Oberseite. Ein solcher Bedienknebel ist beispielsweise in ähnlicher Form aus der DE 20 2005 019 978 U1 bekannt. Durch eine an dem Bedienknebel verlaufende, gestrichelt dargestellte elektrische Verbindung 128 ist der Kontakt zu einem auf der Drehwelle 121 sitzenden Kontaktring 139 hergestellt. Hier greift ein Schleifer 131 samt elektrischer Verbindung zu der Steuerung 125 an, so dass die Steuerung 125 erkennen kann, wenn eine Hand 129 den Bedienknebel 119 bzw. den Berührungssensor 127 berührt hat. Das Funktionsprinzip des Berührungssensors 127 samt Steuerung 125 kann das eines in der DE 20 2005 019 978 U1 beschriebenen kapazitiven Sensors sein. Der Berührungssensor kann auch mit einer isolierenden Beschichtung überzogen sein oder unter einer Abdeckung am Bedienknebel sitzen. Wichtig bei der Ausbildung als kapazitiver Sensor ist eben, dass er kapazitiv eine Berührung mit der Hand erkennen kann und dies an die Steuerung weitergibt. Bei genügend großer Empfindlichkeit kann mit einem derartigen kapazitiven Sensor auch ein Näherungssensor aufgebaut sein, da die kapazitive Kopplung zwischen Sensor und Hand auch eine Strecke von einigen cm durch die Luft überbrückt.

Der Vorteil bei der Anordnung gemäß Fig. 3 mit einem Berührungssensor 127 am Bedienknebel 119 liegt darin, dass erst das tatsächlich erfolgte Berühren des Bedienknebels 119 mit einer Hand 129 erkannt wird bzw. das Aktivieren der Aktuatoreinrichtung 123 ausgelöst wird über die Steuerung 125. Eine Bedienperson muss dann zwar den Bedienknebel erst berühren, damit die Aktuatoreinrichtung 123 anspricht. Dies kann jedoch so schnell erfolgen, dass es nicht oder nur kaum auffällt. Vor allem ist dann eine sichere Erkennung einer Berührung möglich.

## Patentansprüche

1. Bedieneinrichtung für ein Elektrogerät wie vorteilhaft ein Haushalts-Elektrogerät, wobei die Bedieneinrichtung mindestens ein bewegbares Bedienelement aufweist zur Bedienung durch Bewegung des Bedienelements, wobei das Bedienelement mit einer Aktuatoreinrichtung kraftverbunden ist zur haptischen Rückmeldung bei Bewegung des Bedienelementes in Abhängigkeit von der Bedienung bzw. Bewegung, **dadurch gekennzeichnet, dass** die Bedieneinrichtung einen Näherungs- oder Berührungssensor aufweist und eine Steuerschaltung, um die Aktuatoreinrichtung von einem Nortnal-Modus in einen stromsparenden Stand-by-Modus zu versetzen, wobei die Steuerschaltung dazu ausgebildet ist, in einem ersten Fall von erkannter Annäherung oder Berührung des Bedienelements die Aktuatoreinrichtung von dem stromsparenden Stand-by-Modus in den Normal-Modus zu versetzen, und in einem zweiten Fall von nicht vorliegender Annäherung oder Berührung des Bedienelements die Aktuatoreinrichtung von dem Normal-Modus in den stromsparenden Stand-by-Modus zu versetzen bzw. zu belassen.

2. Bedieneinrichtung nach Anspruch 1, **dadurch gekennzeichnet, dass** im Stand-by-Modus die Aktuatoreinrichtung von einer Energieversorgung getrennt ist, wobei sie insbesondere deaktiviert ist.

3. Bedieneinrichtung nach Anspruch 1 oder 2, **dadurch gekennzeichnet, dass** das Bedienelement ein Drehknebel ist mit einer Drehachse, vorzugsweise montiert auf einer starren Drehwelle, wobei die Aktuatoreinrichtung mit der Drehwelle verbunden ist zur Einwirkung auf die Drehwelle.

4. Bedieneinrichtung nach einem der vorhergehenden Ansprüche, **dadurch gekennzeichnet, dass** der Näherungs- oder Berührungssensor an einer Bedienblende bzw. dahinter angeordnet ist, an der das Bedienelement angeordnet ist, wobei er als reiner Näherungssensor ausgebildet ist.

5. Bedieneinrichtung nach einem der vorhergehenden Ansprüche, **dadurch gekennzeichnet, dass** mehrere Bedienelemente an einer Bedienblende angeordnet sind, wobei ein einziger Näherungssensor für mehrere Bedienelemente vorgesehen ist, vorzugsweise ein einziger Näherungssensor für alle Bedienelemente.

6. Bedieneinrichtung nach einem der Ansprüche 1 bis 3, **dadurch gekennzeichnet, dass** der Näherungs- oder Berührungssensor an dem Bedienelement selber angeordnet ist, wobei er vorzugsweise als reiner Berührungssensor ausgebildet ist.

7. Bedieneinrichtung nach einem der vorhergehenden Ansprüche, **dadurch gekennzeichnet, dass** der Näherungs- oder Berührungssensor als optischer Sensor mit einer Reflektions-Lichtschranke ausgebildet ist, vorzugsweise als Näherungssensor.

8. Bedieneinrichtung nach einem der Ansprüche 1 bis 6, **dadurch gekennzeichnet, dass** der Näherungs- oder Berührungssensor als kapazitiver Sensor ausgebildet ist, insbesondere mit einer elektrisch leitfähigen Sensorfläche als Sensorelement, wobei vorzugsweise die Sensorfläche frei liegt zur Berührung und elektrischen Kontaktierung und der Sensor als reiner Berührungssensor ausgebildet ist.

9. Bedieneinrichtung nach einem der vorhergehenden Ansprüche, **dadurch gekennzeichnet, dass** die Aktuatoreinrichtung ein Elektromotor oder ein Piezomotor ist oder mit Magnetostriktion arbeitet.

10. Verfahren zum Betrieb einer Bedieneinrichtung nach einem der vorhergehenden Ansprüche, **dadurch gekennzeichnet, dass** in dem Fall, dass mittels des Näherungs- oder Berührungssensors das Entfernen einer Hand von der Bedieneinrichtung bzw. einem Bedienelement erkannt wird, die Aktuatoreinrichtung umgehend von dem Normal-Modus in den Stand-by-Modus versetzt wird.

11. Verfahren zum Betrieb einer Bedieneinrichtung nach einem der Ansprüche 1 bis 9, **dadurch gekennzeichnet, dass** für den Fall, dass mittels des Näherungs- oder Berührungssensors das Entfernen einer Hand von der Bedieneinrichtung bzw. einem Bedienelement erkannt wird, die Aktuatoreinrichtung noch für eine gewisse Zeitspanne im Normal-Modus mit aktivierter Aktuatoreinrichtung belassen wird, insbesondere maximal wenige Minuten, vorzugsweise eine halbe Minute.

12. Verfahren zum Betrieb einer Bedieneinrichtung nach einem der Ansprüche 1 bis 9, **dadurch gekennzeichnet, dass** für den Fall, dass mittels des Näherungs- oder Berührungssensors eine Annäherung an oder Berührung eines Bedienelements erkannt wird, die Aktuatoreinrichtungen aller Bedienelemente vom Stand-by-Modus in den Normal-Modus versetzt bzw. aktiviert werden.

13. Verfahren zum Betrieb einer Bedieneinrichtung nach einem der Ansprüche 1 bis 9, **dadurch gekennzeichnet, dass** mittels des Näherungs- oder Berührungssensors im Falle einer nicht eindeutig erkannten Annäherung oder Berührung eines Bedienelements durch eine Hand stets der Fall einer solchen Annäherung oder Berührung angenommen wird und die Aktuatoreinrichtung dieses Bedienelements, insbesondere alle Aktuatoreinrichtungen aller Bedienelemente, vom Stand-by-Modus in den Normal-Modus versetzt bzw. aktiviert wird.

## Claims

1. Operating device for an electrical appliance such as advantageously a household electrical appliance, where the operating device has at least one movable operating element for operation by movement of the operating element, where the operating element is positively connected to an actuator device for haptic feedback in the event of movement of the operating element depending on the operation/movement, **characterized in that** the operating device has a proximity or contact sensor and a control circuit for changing the actuator device from a normal mode to a current-saving standby mode, where the control circuit is designed to change the actuator device, in a first case of detected approach or touching of the operating element, from the current-saving standby mode to the normal mode, and to change or leave the actuator device, in a second case of non-existent approach or touching of the operating element, from the normal mode to the current-saving standby mode.

2. Operating device according to Claim 1, **characterized in that** in the standby mode the actuator device is disconnected from an energy supply, where it is in particular deactivated.

3. Operating device according to Claim 1 or 2, **characterized in that** the operating element is a rotary knob with a rotary axis, preferably mounted on a rigid rotary shaft, where the actuator device is connected to the rotary shaft in order to act on the rotary shaft.

4. Operating device according to one of the preceding claims, **characterized in that** the proximity or contact sensor is arranged on or behind a control panel on which the operating element is arranged, where it is designed as a pure proximity sensor.

5. Operating device according to one of the preceding claims, **characterized in that** several operating elements are arranged on a control panel, where a single proximity sensor is provided for several operating elements, and preferably a single proximity sensor for all operating elements.

6. Operating device according to one of Claims 1 to 3, **characterized in that** the proximity or contact sensor is arranged on the operating element itself, where it is preferably designed as a pure contact sensor.

7. Operating device according to one of the preceding claims, **characterized in that** the proximity or contact sensor is designed as an optical sensor with a reflection light barrier, and preferably as a proximity sensor.

8. Operating device according to one of Claims 1 to 6, **characterized in that** the proximity or contact sensor is designed as a capacitive sensor, in particular with an electrically conducting sensor surface as the sensor element, where the sensor surface is preferably exposed for touching and electrical contact and the sensor is designed as a pure contact sensor.

9. Operating device according to one of the preceding claims, **characterized in that** the actuator device is an electric motor or a piezo motor or operates by magnetostriction.

10. Method for operating an operating device according to one of the preceding claims, **characterized in that** in the case where removal of a hand from the operating device or from an operating element is detected by the proximity or contact sensor, the actuator device is immediately changed from the normal mode to the standby mode.

11. Method for operating an operating device according to one of Claims 1 to 9, **characterized in that** in the case where removal of a hand from the operating device or from an operating element is detected by the proximity or contact sensor, the actuator device is left for a certain period in the normal mode with activated actuator device, in particular for several minutes at most, and preferably for half a minute.

12. Method for operating an operating device according to one of Claims 1 to 9, **characterized in that** in the case where an approach or touching of an operating element is detected by the proximity or contact sensor, the actuator devices of all operating elements are changed to the normal mode or activated.

13. Method for operating an operating device according to one of Claims 1 to 9, **characterized in that** in the case of a not clearly detected approach or touching of an operating element by a hand, the case of such an approach or touching is always assumed by the proximity or contact sensor, and the actuator device of this operating element, in particular all actuator devices of all operating elements, is changed from the standby mode to the normal mode or activated.

## Revendications

1. Dispositif de commande pour un appareil électrique tel que de préférence un appareil électroménager, sachant que le dispositif de commande présente au moins un élément de commande mobile permettant la commande par déplacement de l'élément de commande, que l'élément de commande est relié par force à un dispositif d'actionneur pour permettre une réaction haptique lors d'un mouvement de l'élément de commande en fonction de la commande ou du mouvement, **caractérisé en ce que** le dispositif de commande présente un capteur tactile ou de proximité et un circuit de commande pour basculer le dispositif d'actionneur du mode normal à un mode veille à faible consommation électrique, sachant que le circuit de commande est conçu de manière à basculer en mode normal le dispositif d'actionneur se trouvant en mode veille à faible consommation électrique en cas de proximité ou de contact détecté de l'élément de commande, et à basculer le dispositif d'actionneur du mode normal au mode veille à faible consommation électrique ou à le laisser dans ce mode si aucun contact ou proximité de l'élément de commande n'est détecté.

2. Dispositif de commande selon la revendication 1, **caractérisé en ce qu'**en mode veille, le dispositif d'actionneur est séparé d'une alimentation en énergie, sachant qu'il est en particulier désactivé.

3. Dispositif de commande selon la revendication 1 ou 2, **caractérisé en ce que** l'élément de commande est une manette rotative avec un axe de rotation, montée de préférence sur un arbre tournant rigide, sachant que le dispositif d'actionneur est relié à l'arbre tournant pour agir sur l'arbre tournant.

4. Dispositif de commande selon l'une des revendications précédentes, **caractérisé en ce que** le capteur tactile ou de proximité est disposé sur ou derrière un bandeau de commande sur lequel est disposé l'élément de commande, sachant qu'il est conçu sous forme de pur capteur de proximité.

5. Dispositif de commande selon l'une des revendications précédentes, **caractérisé en ce que** plusieurs éléments de commande sont disposés sur un bandeau de commande, sachant qu'un seul capteur de proximité est prévu pour plusieurs éléments de commande, de préférence un seul capteur de proximité pour tous les éléments de commande.

6. Dispositif de commande selon l'une des revendications 1 à 3, **caractérisé en ce que** le capteur tactile ou de proximité est disposé sur l'élément de commande même, sachant qu'il est conçu de préférence sous forme de pur capteur tactile.

7. Dispositif de commande selon l'une des revendications précédentes, **caractérisé en ce que** le capteur tactile ou de proximité est conçu sous forme de capteur optique avec une barrière photoélectrique à réflexion, de préférence sous forme de capteur de proximité.

8. Dispositif de commande selon l'une des revendications 1 à 6, **caractérisé en ce que** le capteur tactile ou de proximité est conçu sous forme de capteur capacitif, en particulier avec une surface de détection conduisant l'électricité comme élément capteur, sachant que la surface du capteur est de préférence libre pour le contact tactile et la mise en contact électrique, et que le capteur est conçu sous forme de pur capteur tactile.

9. Dispositif de commande selon l'une des revendications précédentes, **caractérisé en ce que** le dispositif d'actionneur est un moteur électrique ou un moteur piézoélectrique ou fonctionne par magnétostriction.

10. Procédé de fonctionnement d'un dispositif de commande selon l'une des revendications précédentes, **caractérisé en ce qu'**en cas de détection de l'éloignement d'une main du dispositif de commande ou d'un élément de commande au moyen du capteur tactile ou de proximité, le dispositif d'actionneur est immédiatement basculé du mode normal en mode veille.

11. Procédé de fonctionnement d'un dispositif de commande selon l'une des revendications 1 à 9, **caractérisé en ce qu'**en cas de détection de l'éloignement d'une main du dispositif de commande ou d'un élément de commande au moyen du capteur tactile ou de proximité, le dispositif d'actionneur est laissé pour une certaine durée en mode normal, avec le dispositif d'actionneur activé, en particulier pendant quelques minutes au maximum, de préférence pendant une demi-minute.

12. Procédé de fonctionnement d'un dispositif de commande selon l'une des revendications 1 à 9, **caractérisé en ce qu'**en cas de contact ou de proximité d'un élément de commande détecté par le capteur tactile ou de proximité, les dispositifs d'actionneur de tous les éléments de commande sont basculés du mode veille en mode normal, c'est-à-dire activés.

13. Procédé de fonctionnement d'un dispositif de commande selon l'une des revendications 1 à 9, **caractérisé en ce que** si une main en contact ou à proximité d'un élément de commande n'est pas précisément détectée par le capteur tactile ou de proximité, ce contact ou cette proximité est toujours considéré(e) comme réel(le) et le dispositif d'actionneur de cet élément de commande, en particulier tous les dispositifs d'actionneur de tous les éléments de commande, sont basculés du mode veille en mode normal, c'est-à-dire activés.
